Europäisches Patentamt

European Patent Office

Office européen des brevets

(19)

(11) **EP 1 031 883 B1**

(12) **FASCICULE DE BREVET EUROPEEN**

(45) Date de publication et mention
de la délivrance du brevet:
**03.12.2003 Bulletin 2003/49**

(51) Int Cl.⁷: **G03F 7/20**, H01L 21/68,
B23Q 1/30

(21) Numéro de dépôt: **00400435.4**

(22) Date de dépôt: **16.02.2000**

(54) **Procédé et dispositif pour déplacer un mobile sur une base montée élastiquement par rapport au sol**

Methode und Vorrichtung zur Verschiebung einer beweglichen Masse auf einer elastisch gelagerten Unterlage

Method and device for displacement of a mobile on a base elastically fixed to ground

(84) Etats contractants désignés:
**AT BE CH CY DE DK ES FI FR GB GR IE IT LI LU MC NL PT SE**

(30) Priorité: **23.02.1999 FR 9902224**

(43) Date de publication de la demande:
**30.08.2000 Bulletin 2000/35**

(73) Titulaire: **MICRO CONTROLE SA**
**91006 Evry Cédex (FR)**

(72) Inventeurs:
- **Desailly, Roger**
  **45510 Vienne en Val (FR)**
- **Levine, Jean**
  **75004 Paris (FR)**
- **Nguyen, van Diêp**
  **77140 Nemours (FR)**
- **Maneuf, Serge**
  **45200 Amilly (FR)**

(74) Mandataire: **Bonnetat, Christian**
**CABINET BONNETAT**
**29, rue de St. Pétersbourg**
**75008 Paris (FR)**

(56) Documents cités:
**US-A- 4 525 659**      **US-A- 5 062 012**
**US-A- 5 172 160**      **US-A- 5 446 519**
**US-A- 5 812 958**

- **PATENT ABSTRACTS OF JAPAN vol. 1998, no. 10, 31 août 1998 (1998-08-31) & JP 10 144601 A (NIKON CORP), 29 mai 1998 (1998-05-29)**
- **PATENT ABSTRACTS OF JAPAN vol. 1998, no. 4, 31 mars 1998 (1998-03-31) & JP 09 330875 A (NIKON CORP), 22 décembre 1997 (1997-12-22)**
- **PATENT ABSTRACTS OF JAPAN vol. 1996, no. 8, 30 août 1996 (1996-08-30) & JP 08 088167 A (CANON INC), 2 avril 1996 (1996-04-02)**
- **PATENT ABSTRACTS OF JAPAN vol. 15, no. 149 (P-1190), 15 avril 1991 (1991-04-15) & JP 03 021894 A (NIKON CORP), 30 janvier 1991 (1991-01-30)**

**Description**

La présente invention concerne un procédé et un dispositif pour déplacer un mobile sur une base montée élastiquement par rapport au sol.

Dans le cadre de la présente invention, ledit dispositif comporte, en plus du mobile et de la base, un actionneur commandable, par exemple un moteur électrique, destiné à engendrer un déplacement linéaire du mobile sur la base.

Cette dernière est montée sur le sol par l'intermédiaire de supports élastiques qui sont destinés à l'isoler des vibrations provenant dudit sol.

Toutefois, lors de la mise en mouvement du mobile, durant les phases d'accélération et de décélération, la base est soumise à la réaction de la force appliquée au mobile par l'actionneur. Cet effort de réaction excite la base qui oscille alors sur ses supports. Ceci perturbe le positionnement relatif du mobile par rapport à la base, et nuit fortement à la précision du dispositif.

Cette erreur de position relative subsiste après la fin du déplacement du mobile et ne disparaît qu'après la stabilisation (qui a lieu bien plus tard) de la base.

On connaît différentes solutions pour remédier à cet inconvénient. Certaines de ces solutions prévoient notamment :

- d'immobiliser la base pendant les phases d'accélération et de décélération par un système de blocage, par exemple électromagnétique, qui est monté en parallèle avec les supports élastiques. Cette solution connue empêche toutefois les supports d'isoler la base des vibrations provenant du sol lors desdites phases d'accélération et de décélération ;
- d'annuler l'effet produit par la force engendrée par l'actionneur, en prévoyant un actionneur additionnel qui est agencé entre la base et le sol et qui engendre une force additionnelle de même amplitude, mais de sens opposé ; ou
- de déplacer un mobile additionnel sur la base selon un déplacement analogue, mais de sens opposé, par rapport au déplacement du mobile, de manière à annuler les effets d'inertie.

Toutefois, aucune de ces solutions connues n'est satisfaisante, puisque leurs efficacités sont réduites et qu'elles nécessitent toutes des moyens supplémentaires (système de blocage, actionneur additionnel, mobile additionnel) qui augmentent notamment la complexité, le coût et l'encombrement du dispositif.

Le document JP 10 144 601 A divulgue un procédé pour déplacer un mobile sur une base montée de façon élastique sous l'action d'une force. Cette force est arrêtée et, au moment exact quand la base oscillante se trouve au point d'inversion, une contre-force est appliquée au mobile dans le sens opposé afin que l'accélération du mobile soit réduite et le retour de la base à sa position initiale soit accéléré.

La présente invention a pour objet de remédier à ces inconvénients. Elle concerne un procédé pour déplacer, de façon extrêmement précise et à coût réduit, un mobile sur une base montée de façon élastique par rapport au sol, ledit mobile étant déplacé linéairement selon un déplacement prédéterminé en distance et en temps, sous l'action d'une force commandable.

A cet effet, ledit procédé est remarquable selon l'invention en ce que :

a) on définit une relation mathématique illustrant les mouvements de l'ensemble formé de la base et du mobile et dépendant de paramètres qui sont relatifs à la base et au mobile et qui sont variables lors d'un déplacement de ce dernier ;
b) à partir de ladite relation mathématique, on détermine, par traitement mathématique, une force qui, appliquée audit mobile, produit un effet combiné :

- d'une part, sur le mobile de sorte qu'il réalise ledit déplacement prédéterminé ; et
- d'autre part, sur la base de sorte au moins qu'elle soit immobile à la fin du déplacement du mobile ; et

c) on applique audit mobile la force ainsi déterminée.

Ainsi, la force appliquée au mobile permet à ce dernier de réaliser le déplacement prédéterminé prévu, notamment en temps et en distance, tout en rendant la base immobile à la fin du déplacement de sorte qu'elle n'oscille pas et ne perturbe pas le positionnement relatif entre elle et le mobile.

Par conséquent, en raison de cet effet ou contrôle combiné du mobile et de la base, on obtient un déplacement extrêmement précis du mobile dans un référentiel indépendant de la base et lié par exemple au sol.

On notera que la mise en oeuvre du procédé conforme à l'invention n'est pas limitée à un déplacement selon un axe unique, mais peut également être appliquée à des déplacements selon plusieurs axes qui peuvent être considérés comme indépendants.

On peut utiliser différentes relations mathématiques, et notamment une relation mathématique obtenue par exemple par déconvolution.

Toutefois, dans le cadre de la présente invention, on utilise à l'étape a) précitée, comme relation mathématique, la relation suivante :

$$y = x - \frac{k1}{k0}\dot{x} + \frac{1}{m}(mB - \frac{k1^2}{k0})xB - \frac{mB}{m}\cdot\frac{k1}{k0}\dot{x}B.$$

dans laquelle :

- y représente une variable fictive ;
- k0 et k1 représentent respectivement la fréquence propre et l'amortissement de la base montée élastiquement ;
- m et mB représentent les masses respectivement du mobile et de la base ;
- x et xB représentent les déplacements respectivement du mobile et de la base ; et
- $\dot{x}$ et $\dot{x}B$ représentent les vitesses de déplacement respectivement du mobile et de la base.

En ce qui concerne l'étape b) du procédé conforme à l'invention, on peut réaliser différents traitements mathématiques et en particulier des traitements qui utilisent :

- une somme de fonctions sinusoïdales ; ou
- une décomposition polynomiale.

Pour ce dernier type de traitement, de façon avantageuse, on détermine la force F, à partir de la relation suivante :

$$F = m\ddot{y} + m\frac{k1}{k0}y^{(3)} + \frac{mmB}{k0}y^{(4)}$$

$\ddot{y}$, $y^{(3)}$ et $y^{(4)}$ étant les dérivées respectivement d'ordre 2, 3 et 4 de la variable y, en utilisant la décomposition polynomiale suivante de y(t) : $y(t) = y0 + (y1 - y0)s^5(126 - 420s + 540s^2 - 315s^3 + 70s^4)$,

avec $s = \frac{t-t0}{t1-t0}$, y0 = y(t0) et y1 = y(t1),

t étant le temps et t0 et t1 étant les instants de début et de fin de déplacement du mobile.

La présente invention concerne également un dispositif pour réaliser le procédé conforme à l'invention du type comportant :

- une base montée de façon élastique par rapport au sol ;
- un mobile susceptible d'être déplacé linéairement sur ladite base ; et
- un actionneur commandable susceptible d'appliquer une force audit mobile en vue de son déplacement sur ladite base.

Selon l'invention, ledit dispositif est remarquable en ce qu'il comporte de plus des moyens, par exemple un calculateur :

- qui mettent en oeuvre les étapes a) et b) du procédé précité, pour calculer une force qui, appliquée audit mobile, permet d'obtenir l'effet combiné indiqué précédemment ; et
- qui déterminent un ordre de commande et le transmettent audit actionneur pour qu'il applique au mobile la force ainsi calculée, lors d'un déplacement.

Ainsi, en plus des avantages précités, le dispositif conforme à l'invention ne nécessite pas de moyen mécanique additionnel, ce qui réduit son coût et son encombrement et simplifie sa réalisation, par rapport aux dispositifs connus et précités.

Les figures du dessin annexé feront bien comprendre comment l'invention peut être réalisée. Sur ces figures, des références identiques désignent des éléments semblables.

La figure 1 est le schéma synoptique d'un dispositif conforme à l'invention.

Les figures 2 et 3 représentent des graphiques qui illustrent les déplacements, respectivement du mobile et de la base, lors d'une mise en mouvement conforme à l'invention dudit mobile.

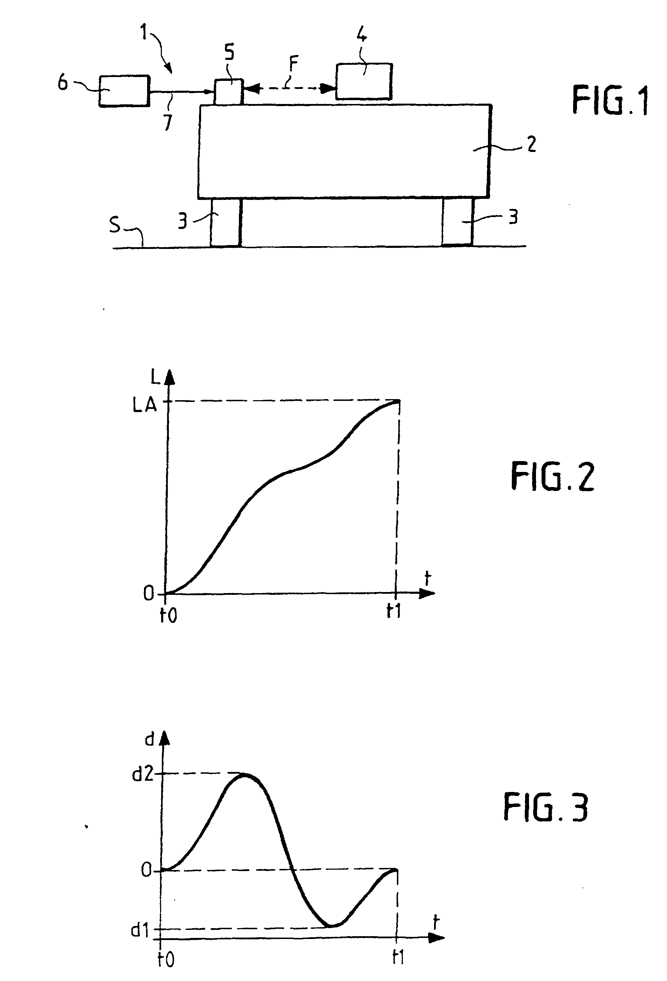

Le dispositif 1 conforme à l'invention et représenté schématiquement sur la figure 1 est destiné au déplacement d'un mobile 4, par exemple un chariot mobile, sur une base 2, en particulier un banc d'essai.

Ce dispositif 1 peut par exemple être appliqué à des tables XY rapides utilisées en micro-électronique, à des machines-outils, à des convoyeurs, à des robots, ...

De façon connue, ledit dispositif 1 comporte, en plus de la base 2 et du mobile 4 :

- des supports élastiques 3, de type connu, agencés entre la base 2 et le sol S et permettant d'isoler la base 2 des vibrations provenant dudit sol S. La fréquence propre de la base 2 sur lesdits supports élastiques 3 est généralement de quelques hertz ;
- des moyens non représentés, par exemple un rail, fixés sur la base 2 et permettant au mobile 4 de se déplacer de façon linéaire sur ladite base 2 ; et
- un actionneur commandable 5, de préférence un moteur électrique, susceptible d'appliquer une force F audit mobile 4 en vue de son déplacement sur la base 2.

Selon l'invention, ledit dispositif 1 est perfectionné de manière à obtenir directement à la fin d'un déplacement du mobile 4 un positionnement précis de ce dernier dans un référentiel non représenté, indépendant du mobile et de la base et lié par exemple au sol, en remédiant aux problèmes dus à la mise en oscillation de la base 2 lors de l'accélération et de la décélération du mobile 4.

Pour ce faire, le dispositif 1 comporte de plus, selon l'invention, des moyens de calcul 6 qui calculent une force particulière F, qui est destinée à être transmise sous forme d'un ordre de commande à l'actionneur 5 et qui est telle qu'appliquée audit mobile 4, elle permet un effet combiné (et donc un contrôle combiné) :

- d'une part, sur le mobile 4 de sorte qu'il réalise exactement le déplacement prévu, notamment concernant la durée et la distance prescrites de déplacement ; et
- d'autre part, sur la base 2 de sorte au moins qu'elle soit immobile à la fin du déplacement du mobile 4.

Ainsi, comme grâce au dispositif 1, la base 2 est immobilisée à la fin du déplacement, elle ne perturbe pas le positionnement du mobile 4 dans le référentiel précité de sorte que ledit mobile 4 est positionné de façon stable dès la fin de son déplacement. De plus, comme son déplacement est réalisé de façon précise, son positionnement correspond exactement dans ledit référentiel au positionnement recherché.

Pour ce faire, selon l'invention, lesdits moyens 6 :

a) définissent une relation mathématique illustrant les mouvements de l'ensemble formé de la base 2 et du mobile 4 et dépendant de paramètres qui sont relatifs à la base 2 et au mobile 4 et qui sont variables lors d'un déplacement de ce dernier ; et

b) à partir de ladite relation mathématique, déterminent, par traitement mathématique, une force F qui, appliquée audit mobile 4, produit l'effet combiné précité.

Dans le cadre de la présente invention, différentes relations mathématiques peuvent être utilisées et différents traitements mathématiques peuvent être mis en oeuvre.

Avant de présenter un mode de calcul préféré, on précise les conditions et les hypothèses du problème considéré, à savoir :

- le mobile 4 présente une masse $\underline{m}$ et se déplace sans frottement sur la base 2 de masse mB ;
- la base 2 est reliée au sol S de façon élastique avec une raideur k0 et un amortissement k1 ; et
- les mouvements de la base 2 sont supposés restreints à des déplacements parallèles au déplacement du mobile 4.

A titre d'illustration, pour des masses :

$$\begin{cases} m = 40 \text{ kg} \\ mB = 800 \text{ kg,} \end{cases}$$

on obtient :

$$\sqrt{k0/mB} = 5\text{Hz}$$

$$k1/\sqrt{k0mB} = 0{,}3$$

En prenant en compte de plus :

- x la position du centre de masse du mobile 4 dans le référentiel précité et lié par exemple au sol S ;
- xB la position du centre de masse de la base 2 dans ledit référentiel ; et
- F la force appliquée au mobile 4,

le bilan des forces s'écrit :

$$\begin{cases} m\ddot{x} = F \\ mB\,\ddot{x}B = -F - k0xB - k1\dot{x}B \end{cases}$$

Dans le cadre de la présente invention les moyens 6 utilisent à l'étape a) précitée, comme valeur mathématique, la variable fictive y suivante :

$$y = x - \frac{k1}{k0}\dot{x} + \frac{1}{m}(mB - \frac{k1^2}{k0})xB - \frac{mB}{m}\cdot\frac{k1}{k0}\dot{x}B. \tag{1}$$

Cette variable présente la propriété remarquable de résumer tous les mouvements de l'ensemble formé du mobile 4 et de la base 2. En effet, la position et la vitesse de la base 2 et du mobile 4, ainsi que la force F s'expriment en fonction de y et de ses dérivées jusqu'à l'ordre 4 ($y^{(i)}$ étant la dérivée d'ordre $i$ de y).

$$\begin{cases} x = y + \frac{k1}{k0}\dot{y} + \frac{mB}{k0}\ddot{y} \\[2mm] \dot{x} = \dot{y} + \frac{k1}{k0}\ddot{y} + \frac{mB}{k0}y^{(3)} \\[2mm] xB = -\frac{m}{k0}\ddot{y} \\[2mm] \dot{x}B = -\frac{m}{k0}y^{(3)} \\[2mm] F = m\ddot{y} + m\frac{k1}{k0}y^{(3)} + \frac{mmB}{k0}y^{(4)} \end{cases} \tag{2}$$

Ainsi, si l'on veut engendrer les déplacements voulus du mobile 4 et de la base 2, il suffit de prévoir une trajectoire de y, polynomiale par rapport au temps, qui interpole les conditions initiales et finales, à savoir le mobile 4 se déplace d'une position x0 au repos ($\dot{x}0 = 0$) à un instant t0 de début de déplacement, à une position x1 au repos ($\dot{x}1 = 0$) à un instant t1 de fin de déplacement, et la base 2 est immobile ($\dot{x}B = 0$) aux instants t0 et t1 à la position d'équilibre xB.
Par conséquent, on obtient :

$$\begin{cases} x(t0) = x0, \ \dot{x}(t0) = 0, \ xB(t0) = 0, \ \dot{x}B(t0) = 0, \ F(t0) = 0 \\ x(t1) = x1, \ \dot{x}(t1) = 0, \ xB(t1) = 0, \ \dot{x}B(t1) = 0, \ F(t1) = 0 \end{cases}$$

c'est-à-dire :

$$\begin{cases} y(t0) = x0, \ \dot{y}(t0) = 0, \ \ddot{y}(t0) = 0, \ y^{(3)}(t0) = 0, \ y^{(4)}(t0) = 0 \\ y(t1) = x1, \ \dot{y}(t1) = 0, \ \ddot{y}(t1) = 0, \ y^{(3)}(t1) = 0, \ y^{(4)}(t1) = 0. \end{cases}$$

Pour obtenir une trajectoire polynomiale exploitable en ce qui concerne y, le degré minimal, compte tenu du fait qu'il y a 10 conditions initiales et finales, est égal à 9, c'est-à-dire :

$$y(t) = y0 + (y1 - y0)s^5(126 - 420s + 540s^2 - 315s^3 + 70s^4), \tag{3}$$

avec $s = \dfrac{t - t0}{t1 - t0}$, $y0 = y(t0)$ et $y1 = y(t1)$ .

La force F, ainsi que les paramètres x, $\dot{x}$, xB et $\dot{x}$B sont ensuite déduits à partir des relations (2) précitées et de la relation (3).

Sur les figures 2 et 3, on a représenté les déplacements L et d entre les instants t0 et t1, respectivement du mobile 4 et de la base 2, non dans le référentiel lié au sol et précité, mais dans des repères unidirectionnels liés à ces derniers.

Ainsi, le mobile 4 est déplacé d'une distance LA, telle que LA = x1-x0.

La base 2 s'est déplacée au maximum respectivement de distances d1 et d2 de part et d'autre de la position d'équilibre xB, cette position d'équilibre correspondant à la distance d = 0 de la figure 3.

Bien entendu, le mode de mise en oeuvre décrit précédemment n'est pas le seul possible dans le cadre de la présente invention.

Ainsi, dans un mode de réalisation particulier, on peut utiliser une formulation différente de celle précitée et tenant également compte de la variable fictive y [relation (1) précitée]. Dans ce cas, on utilise :

- Y la transformée de Laplace de ladite variable fictive y ; et
- X, Xb et F1 les transformées de Laplace des variables temporelles x, xB et F définies dans les relations (2) précitées.

Cette formulation comprend trois polynômes P0(p), Px(p) et Pb(p) de la variable p de Laplace qui vérifient :

$$\begin{cases} F1 = P0(p).Y \\ X = Px(p).Y \\ Xb = Pb(p).Y \end{cases}$$

Par ailleurs, dans l'étape b), au lieu de mettre en oeuvre un traitement mathématique comprenant une décomposition polynomiale, comme décrit ci-dessus, on peut mettre en oeuvre un traitement mathématique comprenant par exemple une somme de fonctions sinusoïdales.

En particulier, on peut utiliser une décomposition sinusoïdale de la forme :

$$y(t) = y0 + (y1 - y0).\sum_{k=1}^{k=n} ak.\sin[(k\pi / 2).(t - t0 / t1 - t0) + \varphi k]$$

dans laquelle :

- y1 et y0 sont les positions finale et initiale ; et
- t1 et t0 sont les temps final et initial, tel qu'indiqué ci-dessus.

De plus, ak et $\varphi$k sont des paramètres qui sont déterminés à l'aide des mêmes conditions initiales et finales que celles indiquées précédemment.

**Revendications**

1. Procédé pour déplacer un mobile (4) sur une base (2) montée de façon élastique par rapport au sol (S), ledit mobile (4) étant déplacé linéairement selon un déplacement prédéterminé sous l'action d'une force (F) commandable,

   **caractérisé en ce que** :

   a) on définit une variable fictive y qui illustre les mouvements de l'ensemble formé de la base (2) et du mobile (4) par la relation mathématique suivante :

   $$y = x - \frac{k1}{k0}\dot{x} + \frac{1}{m}(mB - \frac{k1^2}{k0})xB - \frac{mB}{m}.\frac{k1}{k0}\dot{x}B.$$

   dans laquelle :

   - k0 et k1 représentent respectivement la fréquence propre et l'amortissement de la base (2) montée élastiquement ;
   - m et mB représentent les masses respectivement du mobile (4) et de la base (2) ;
   - x et xB représentent les déplacements respectivement du mobile (4) et de la base (2) ; et
   - $\dot{x}$ et $\dot{x}$B représentent les vitesses de déplacement respectivement du mobile (4) et de la base (2),

   ladite variable fictive y dépendant desdits paramètres x, xB, $\dot{x}$ et $\dot{x}$B qui sont relatifs à la base (2) et au mobile (4) et qui sont variables lors d'un déplacement de ce dernier ;
   b1) on réalise une décomposition de ladite variable fictive y, en prenant en compte des conditions initiales et finales permettant de produire un effet combiné :

   - d'une part, sur le mobile (4) de sorte qu'il réalise ledit déplacement linéaire prédéterminé ; et
   - d'autre part, sur la base (2) de sorte au moins qu'elle soit immobile à la fin du déplacement du mobile (4) ;

   b2) on définit, en fonction de ladite variable fictive y et de dérivées de cette dernière, une expression théorique d'une force F à appliquer au mobile (4) pour qu'il se déplace sur la base (2) ;
   b3) à partir de l'expression théorique définie à l'étape b2) et de la décomposition réalisée à l'étape b1), on calcule la force (F) qui doit être appliquée audit mobile (4) pour produire ledit effet combiné ; et
   c) on détermine un ordre de commande représentatif de ladite force (F) calculée à l'étape b3) et on le transmet à un actionneur dudit mobile pour qu'il applique audit mobile (4) ladite force (F), de sorte que ce dernier réalise ledit déplacement linéaire prédéterminé sur ladite base (2).

2. Procédé selon la revendication 1,
   **caractérisé en ce qu'**à l'étape b1), on réalise une décomposition sinusoïdale de ladite variable fictive y, de la forme :

$$y(t) = y0 + (y1 - y0).\sum_{k=1}^{k=n} ak.\sin[(k\pi/2).(t - t0/t1 - t0) + \varphi k]$$

dans laquelle :

- t est le temps ;
- t1 et t0 sont les instants de début et de fin de déplacement du mobile (4) sur la base (2) ;
- y1 et y0 sont les valeurs de y, respectivement auxdits temps t1 et t0 ; et
- ak et $\varphi$k sont des coefficients prédéterminés.

3. Procédé selon la revendication 1,
   **caractérisé en ce qu'**à l'étape b1), on réalise une décomposition polynomiale de ladite variable fictive y, de la forme :

$$y(t) = y0 + (y1 - y0)s^5(126 - 420s + 540s^2 - 315s^3 + 70s^4),$$

dans laquelle :

- $\underline{t}$ est le temps, et t0 et t1 sont les instants de début et de fin de déplacement du mobile (4) ; et
- $\underline{s} = \frac{t - t0}{t1 - t0}$, y0 = y(t0) et y1 = y(t1),

4. Procédé selon l'une des revendications 1 et 3,
   **caractérisé en ce qu'**à l'étape b2), on détermine la force F, à partir de la relation suivante :

$$F = m\ddot{y} + m\frac{k1}{k0}y^{(3)} + \frac{mmB}{k0}y^{(4)},$$

$\ddot{y}$, $y^{(3)}$ et $y^{(4)}$ étant les dérivées respectivement d'ordre 2, 3 et 4 de la variable y, en utilisant la décomposition polynomiale suivante de y(t) : $y(t) = y0 + (y1- y0)s^5(126 - 420s + 540s^2 - 315s^3 + 70s^4)$ ,
avec $s = \frac{t - t0}{t1 - t0}$, y0 = y(t0) et y1 = y(t1),
$\underline{t}$ étant le temps et t0 et t1 étant les instants de début et de fin de déplacement du mobile (4).

5. Procédé selon l'une quelconque des revendications précédentes, **caractérisé en ce que** l'on utilise la transformée de Laplace de ladite variable fictive y.

6. Dispositif pour réaliser le procédé selon l'une quelconque des revendications précédentes, comportant :

- une base (2) montée de façon élastique par rapport au sol (S) ;
- un mobile (4) susceptible d'être déplacé linéairement sur ladite base (2) ; et
- un actionneur commandable (5) susceptible d'appliquer une force (F) audit mobile (4) en vue de son déplacement sur ladite base (2),

**caractérisé en ce qu'**il comporte de plus des moyens de calcul (6) :

- qui réalisent une décomposition d'une variable fictive y particulière, qui illustre les mouvements de l'ensemble formé de la base (2) et du mobile (4) par la relation mathématique suivante:

$$y = x - \frac{k1}{k0}\dot{x} + \frac{1}{m}(mB - \frac{k1^2}{k0})xB - \frac{mB}{m} \cdot \frac{k1}{k0}\dot{x}B,$$

en prenant en compte des conditions initiales et finales permettant de produire un effet combiné :

. d'une part, sur le mobile (4) de sorte qu'il réalise ledit déplacement linéaire prédéterminé ; et
. d'autre part, sur la base (2) de sorte au moins qu'elle soit immobile à la fin du déplacement du mobile (4) ;

- qui calculent la force (F) qui doit être appliquée audit mobile (4) pour produire ledit effet combiné, à partir de ladite décomposition de la variable fictive y et d'une expression théorique de la force, définie en fonction de ladite variable fictive y et de dérivées de cette dernière ; et
- qui déterminent un ordre de commande et le transmettent audit actionneur (5) pour qu'il applique audit mobile (4) la force (F) ainsi calculée.

**Claims**

1.  A method for displacing a moving body (4) on a base (2) mounted elastically with respect to the ground (S), said moving body (4) being displaced linearly with a predetermined displacement under the action of a controllable force (F),
    **characterized in that**:

    a) an imaginary variable y that illustrates the movements of the entity formed by the base (2) and the moving body (4) through the following mathematical relationship:

    $$y = x - \frac{k1}{k0}\dot{x} + \frac{1}{m}(mB - \frac{k1^2}{k0})xB - \frac{mB}{m} \cdot \frac{k1}{k0}\dot{x}B$$

    is defined, in which:

    - k0 and k1 respectively represent the natural frequency and the damping of the elastically mounted base (2);
    - m and mB represent the masses of the moving body (4) and of the base (2), respectively;
    - x and xB represent the displacements of the moving body (4) and of the base (2), respectively; and
    - $\dot{x}$ and $\dot{x}$B represent the speeds of displacement of the moving body (4) and of the base (2), respectively, said imaginary variable y depending on said parameters x, xB, $\dot{x}$ and $\dot{x}$B which relate to the base (2) and to the moving body (4) and which can vary during a displacement of the latter;

    b1) said imaginary variable y is expanded, incorporating the initial and final conditions to make it possible to produce a combined effect:

    - on the one hand, on the moving body (4) so that it performs said predetermined linear displacement; and
    - on the other hand, on the base (2) at least so that it is immobile at the end of the displacement of the moving body (4);

    b2) a theoretical expression of a force F to be applied to the moving body (4) to make it move on the base (2) is defined as a function of said imaginary variable y and of derivatives thereof;
    b3) from the theoretical expression defined in step b2) and from the expansion performed at step b1), the force (F) that has to be applied to said moving body (4) in order to produce said combined effect is calculated; and
    c) a command representing said force (F) calculated in step b3) is determined and transmitted to an actuator of said moving body so that it applies said force (F) to said moving body (4) so that this moving body performs said predetermined linear displacement on said base (2).

2.  The method as claimed in claim 1,
    **characterized in that**, in step b1), said imaginary variable y is sinusoidally expanded into the form:

    $$y(t) = y0 + (y1 - y0) . \sum_{k=1}^{k=n} ak . \sin[(k\pi/2) . (t - t0/t1 - t0) + \phi k]$$

    in which:

- t is the time;
- t1 and t0 are the instants of the start and end of the displacement of the moving body (4) on the base (2);
- y1 and y0 are the values of y at said times t1 and t0 respectively; and
- ak and φk are predetermined coefficients.

3. The method as claimed in claim 1,
   **characterized in that**, in step b1), said imaginary variable y is polynomially expanded into the form:

$$y(t) = y0 + (y1 - y0)s^5(126 - 420s + 540s^2 - 315s^3 + 70s^4)$$

in which:

- t is the time, and t0 and t1 are the instants of the start and end of the displacement of the moving body (4); and
- $s = \frac{t-t0}{t1-t0}$, y0 = y(t0) and y1 = y(t1).

4. The method as claimed in either of claims 1 and 3,
   **characterized in that**, in step b2), the force F is determined from the following relationship:

$$F = m\ddot{y} + m\frac{k1}{k0}y^{(3)} + \frac{mmB}{k0}y^{(4)},$$

$\ddot{y}$, $y^{(3)}$ and $y^{(4)}$ being the 2nd, 3rd and 4th-order derivatives of the variable y, respectively, and using the following polynomial expansion of y(t):

$$y(t) = y0 + (y1 - y0)s^5(126 - 420s + 540s^2 - 315s^3 + 70s^4)$$

with $s = \frac{t-t0}{t1-t0}$, y0 = y(t0) and y1 = y(t1),
t being time and t0 and t1 being the instants of the start and end of the displacement of the moving body (4).

5. The method as claimed in any one of the preceding claims, **characterized in that** use is made of the Laplace transform of said imaginary variable y.

6. A device for carrying out the method as claimed in any one of the preceding claims, comprising:

- a base (2) mounted elastically with respect to the ground (S);
- a moving body (4) which can be displaced linearly on said base (2); and
- a controllable actuator (5) capable of applying a force (F) to said moving body (4) with a view to displacing it on said base (2),

**characterized in that** it additionally comprises calculation means (6):

- which expand a specific imaginary variable y that illustrates the movements of the entity formed by the base (2) and the moving body (4) through the following mathematical relationship:

$$y = x - \frac{k1}{k0}\dot{x} + \frac{1}{m}(mB - \frac{k1^2}{k0})xB - \frac{mB}{m} \cdot \frac{k1}{k0}\dot{x}B,$$

incorporating the initial and final conditions to make it possible to produce a combined effect:

  · on the one hand, on the moving body (4) so that it performs said predetermined linear displacement; and
  · on the other hand, on the base (2) at least so that it is immobile at the end of the displacement of the moving body (4);

- which calculate the force (F) which needs to be applied to said moving body (4) in order to produce said combined effect, from said expansion of the imaginary variable y and from a theoretical expression of the force, defined as a function of said imaginary variable y and of derivatives thereof; and

- which determine a control command and transmit it to said actuator (5) so that it applies the force (F) thus calculated to said moving body (4).

**Patentansprüche**

1. Verfahren zur Verschiebung einer beweglichen Masse (4) auf einer in Bezug auf den Boden (S) elastisch gelagerten Unterlage (2), wobei die bewegliche Masse (4) unter der Wirkung einer steuerbaren Kraft (F) linear entlang eines vorherbestimmten Verschiebungswegs verschoben wird,
   **dadurch gekennzeichnet, dass**:

   a) eine fiktive Variable y definiert wird, die die Bewegungen der von der Unterlage (2) und der beweglichen Masse (4) gebildeten Einheit mit der folgenden mathematischen Relation veranschaulicht:

   $$y = x - \frac{k1}{k0}\dot{x} + \frac{1}{m}(mB - \frac{k1^2}{k0})xB - \frac{mB}{m} \cdot \frac{k1}{k0}\dot{x}B$$

   in der:

   - k0 und k1 die Eigenfrequenz beziehungsweise die Dämpfung der elastisch gelagerten Unterlage (2) darstellen;
   - m und mB die Massen der beweglichen Masse (4) beziehungsweise der Unterlage (2) darstellen;
   - x und xB die Verschiebungen der beweglichen Masse (4) beziehungsweise der Unterlage (2) darstellen; und
   - $\dot{x}$ und $\dot{x}$B die Verschiebungsgeschwindigkeiten der beweglichen Masse (4) beziehungsweise der Unterlage (2) darstellen,

   wobei die fiktive Variable y von den Parametern x, xB, $\dot{x}$ und $\dot{x}$B abhängt, die sich auf die Unterlage (2) und die bewegliche Masse (4) beziehen und bei einer Verschiebung letzterer veränderlich sind;
   b1) eine Zerlegung der genannten fiktiven Variablen y durchgeführt wird, indem die Anfangsund Endbedingungen berücksichtigt werden, die es ermöglichen eine kombinierte Wirkung zu erzielen:

   - zum einen an der beweglichen Masse (4), sodass sie die vorbestimmte lineare Verschiebung ausführt; und
   - zum anderen an der Unterlage (2), sodass sie zumindest am Ende der Verschiebung der beweglichen Masse (4) unbeweglich ist;

   b2) in Abhängigkeit von der fiktiven Variablen y und Ableitungen von dieser Variablen ein theoretischer Ausdruck einer Kraft F definiert wird, die auf die bewegliche Masse (4) anzuwenden ist, damit sie sich auf der Unterlage (2) verschiebt;
   b3) ausgehend von dem in Etappe b2) definierten theoretischen Ausdruck und der in Etappe b1) durchgeführten Zerlegung wird die Kraft (F) berechnet, die auf die bewegliche Masse (4) angewandt werden muss, um die kombinierte Wirkung hervorzurufen; und
   c) ein Steuerbefehl ermittelt wird, der repräsentativ für die in Etappe b3) berechnete Kraft (F) ist und zu einem Betätigungsorgan der beweglichen Masse übertragen wird, damit dieses die Kraft (F) auf die bewegliche Masse (4) anwendet, sodass letztere die vorbestimmte lineare Verschiebung auf der Unterlage (2) ausführt.

2. Methode nach Anspruch 1,
   **dadurch gekennzeichnet, dass** in Etappe b1) eine sinusförmige Zerlegung der genannten fiktiven Variablen y der Form:

$$y(t) = y0 + (y1 - y0) \cdot \sum_{k=1}^{k=n} ak \cdot \sin\left[(k\pi/2) \cdot (t - t0/t1 - t0) + \varphi k\right]$$

durchgeführt wird, in der:

- t die Zeit ist;
- t1 und t0 die Momente des Beginns und des Ende der Verschiebung der beweglichen Masse (4) auf der Unterlage (2) sind;
- y1 und y0 die Werte von y zu den Zeiten t1 beziehungsweise t0 sind; und
- ak und φ vorbestimmte Koeffizienten sind.

3. Methode nach Anspruch 1,
   **dadurch gekennzeichnet, dass** in der Etappe b1) eine polynomische Zerlegung der genannten fiktiven Variablen y der Form:

$$y(t) = y0 + (y1 - y0)s^5(126 - 420s + 540s^2 - 315s^3 + 70s^4)$$

durchgeführt wird, in der:

- t die Zeit und t0 und t1 die Momente des Beginns und des Ende der Verschiebung der beweglichen Masse (4) sind und
- $s = \frac{t - t0}{t1 - t0}$, y0 = y(t0) und y1 = y(t1).

4. Methode nach einem der Ansprüche 1 und 3,
   **dadurch gekennzeichnet, dass** in der Etappe b2) die Kraft F ausgehend von folgender Relation ermittelt wird:

$$F = m\ddot{y} + m\frac{k1}{k0}y^{(3)} + \frac{mmB}{k0}y^{(4)},$$

wobei $\ddot{y}$, $y^{(3)}$ und $y^{(4)}$ die Ableitung 2. 3. beziehungsweise 4. Ordnung der Variablen y sind und die folgende Polynomzerlegung von y(t) verwendet wird:

$$y(t) = y0 + (y1 - y0)s^5(126 - 420s + 540s^2 - 315s^3 + 70s^4),$$

mit $s = \frac{t - t0}{t1 - t0}$, y0 = y(t0) und y1 = y(t1)
wobei t die Zeit und t0 und t1 die Momente des Beginns und des Endes der Verschiebung der beweglichen Masse (4) sind.

5. Methode nach einem beliebigen der vorstehenden Ansprüche,
   **dadurch gekennzeichnet, dass** die Laplace-Transformierte der fiktiven Variablen y verwendet wird.

6. Vorrichtung zur Durchführung der Methode nach einem der vorstehenden Ansprüche, die Folgendes umfasst:

- eine Unterlage (2), die elastisch in Bezug auf den Boden (S) montiert ist;
- eine bewegliche Masse (4), die linear auf der Unterlage (2) verschoben werden kann; und
- ein steuerbares Betätigungsorgan (5), das auf die bewegliche Masse (4) zu deren Verschiebung auf der Unterlage (2) eine Kraft (F) anwenden kann,

**dadurch gekennzeichnet, dass** sie außerdem Rechenmittel (6) umfasst,

- die eine Zerlegung einer dafür spezifischen fiktiven Variablen y durchführen, die durch folgende mathematische Relation:

$$y = x - \frac{k1}{k0}\dot{x} + \frac{1}{m}(mB - \frac{k1^2}{k0})xB - \frac{mB}{m}\cdot\frac{k1}{k0}\dot{x}B.$$

die Bewegungen der von Unterlage (2) und beweglicher Masse (4) gebildeten Einheit veranschaulicht, wobei sie die Ausgangs- und Endbedingungen berücksichtigen, die es ermöglichen, eine kombinierte Wirkung:

- zum einen an der beweglichen Masse (4) zu erzielen, sodass diese die vorbestimmte lineare Verschiebung ausführt; und
- zum anderen an der Unterlage (2) zu erzielen, sodass sie zumindest am Ende der Verschiebung der beweglichen Masse (4) unbeweglich ist;

- die die Kraft (F), die auf die bewegliche Masse (4) angewandt werden muss, um die genannte kombinierte Wirkung hervorzurufen, ausgehend von der Zerlegung der fiktiven Variablen y und einem theoretischen Ausdruck der Kraft berechnen, der in Abhängigkeit von der fiktiven Variablen y und Ableitungen letzterer definiert worden ist; und

- die einen Steuerbefehl ermitteln und ihn zum Betätigungsorgan (5) übertragen, damit dieses die so berechnete Kraft (F) auf die bewegliche Masse (4) anwendet.

FIG.1

FIG.2

FIG.3